# EUROPÄISCHE PATENTSCHRIFT

(11) **EP 2 456 073 B1**
(45) Veröffentlichungstag und Bekanntmachung des Hinweises auf die Patenterteilung: **04.01.2017**
(21) Anmeldenummer: 11189070.3
(22) Anmeldetag: 15.11.2011
(51) Int. Cl.: H03K 17/972, H03K 17/95, G01R 33/07

(54) **Vieradriger Sicherheits-Hall-Schalter**
Four core safety hall switch
Commutateur Hall de sécurité à quatre brins

(30) Priorität: 19.11.2010 DE 202010012939 U
(43) Veröffentlichungstag der Anmeldung: 23.05.2012
(73) Patentinhaber: steute Schaltgeräte GmbH & Co. KG, 32584 Löhne (DE)
(72) Erfinder: Heuer, Friedhelm, 32361 Preußisch Oldendorf (DE)
(74) Vertreter: Habbel, Ludwig

(56) Entgegenhaltungen:
- DE-A1- 10 138 342
- DE-A1- 10 249 143
- DE-A1-102005 030 257
- US-A- 5 412 255
- US-A1- 2005 285 581

## Beschreibung

Die Erfindung betrifft einen zweikanaligen Sicherheits-Hall-Schalter.

Aus der DE 41 33 837 A1 ist eine Sensoreinrichtung bekannt. Aus der DE 101 38 342 A1 ist eine Vorrichtung zum Überwachen einer Schließposition zweier relativ zueinander beweglicher Teile, insbesondere zur Verwendung als berührungsloser Türkontaktschalter, bekannt. Aus der DE 196 14 457 A1 ist ein Elektronischer Näherungsschalter bekannt.

Aus der Praxis sind zweikanalige Sicherheitsschalter bekannt, bei denen Reedkontakte verwendet werden. Reedkontakte sind aufgrund ihres üblicherweise verwendeten Glasröhrchens allerdings mechanisch empfindlich, so dass für bestimmte Anwendungsgebiete der Bedarf besteht, diese Reedkontakte durch robustere Sensoren zu ersetzen. Bei einer Ausgestaltung als Sicherheitsschalter, der nur mit einem bestimmten Schlüssel in Form eines kodierten Magneten betätigt werden kann, besteht allerdings das Problem, dass hierfür zwei mit Hall-Sensoren arbeitende Kanäle erforderlich sind, wobei pro Kanal drei Leitungsadern - nämlich für die Sensoren sowie eine Spannungsversorgung - erforderlich sind. Typischerweise muss daher ein dementsprechender Sicherheitsschalter, bei dem eine galvanische Trennung der Kanäle vorgesehen ist, mit insgesamt sechs Anschlussadern angeschlossen werden. Dementsprechend kann ein Reed-Sicherheitsschalter, der lediglich pro Kanal zweiadrig angeschlossenen wird und für den folglich lediglich vier Anschlussadern vorgesehen sind, nicht einfach durch einen derartigen Hall-Sicherheitsschalter ersetzt werden, der sechs Anschlussadern erfordert.

Aus dem Stand der Technik sind zudem Schaltungen bekannt, die sämtlich eine Auswerte-Einheit erfordern, welche die Ausgangssignale des Hall-Sensor auswertet:
Aus der DE 102 49 143 A1 ist eine Sensoranordnung mit 1-Draht-Schnittstelle bekannt, die eine Auswerteschaltung für von einem Hall-Sensor erzeugte Messsignale aufweist.

Aus der DE 101 38 342 A1 ist eine Vorrichtung zum Überwachen einer Schließposition zweier relativ zueinander beweglicher Teile, insbesondere zur Verwendung als berührungsloser Türkontaktschalter bekannt. Mittels eines Fensterkomparators wird das Ausgangssignal des Hall-Sensors einer doppelten Überprüfung unterzogen.

Aus der DE 10 2005 030 257 A1 ist eine Vorrichtung mit Hall-schalter in einem Kraftfahrzeug bekannt, wobei der integrierte Hallschalter einen Hall-Sensor enthält. Die Stromaufnahme des integrierten Hallschalters wird gemessen und ausgewertet.

Auch die US 2005/0285581 A1 zeigt einen Hall-Sensor, dem eine Schnittstellenschaltung und eine Auswerte- bzw. Steuereinheit zugeordnet ist.

Der Erfindung liegt die Aufgabe zugrunde, einen Sicherheits-Hall-Schalter zu schaffen, der mit lediglich vier Anschlussadern angeschlossen werden kann.

Diese Aufgabe wird durch einen zweikanaligen Sicherheits-Hall-Schalter mit den Merkmalen des Anspruchs 1 gelöst.

Der vorschlagsgemäße 4-Leiter-Sicherheitsschalter ist folgendermaßen aufgebaut: Hinter dem Eingang ist in jedem der beiden Kanäle jeweils eine Verpolschutzdiode vorgesehen, der eine Konstantstromquelle folgt, die vorteilhaft aus einem Junction-Field-Effect-Transistor und einem Widerstand bestehen kann, so dass mittels dieser Konstantstromquelle der Leerlaufstrom unabhängig von der Versorgungsspannung annähernd konstant gehalten wird.

Die Versorgungsspannung für die Hall-Sensoren wird in jedem der beiden Kanäle mittels einer Referenz-Spannungsquelle mit einem Bypass-Transistor erzeugt. Dieser Bypass-Transistor dient der Erhöhung des erforderlichen Ausgangsstromes. Eine Spannung von etwa 1,65V bis 1,70V wird über einen Spannungsteiler an der Referenzspannungsquelle eingestellt.

Zwischen der Referenzspannungsquelle und dem erwähnten Bypass-Transistor ist eine Hall-Sensor-Anordnung in jedem der Kanäle vorgesehen sowie ein dieser Hall-Sensor-Anordnung nachgeschalteter Transistor, der im Rahmen des vorliegenden Vorschlags als Zwischentransistor bezeichnet wird.

Der Kanal 1 weist zu Gunsten einer möglichst hohen Manipulationssicherheit zwei Hall-Sensoren auf, deren Ausgänge jeweils einen Transistor ansteuern, wobei diese in Reihe geschaltet einen weiteren Transistor, nämlich den erwähnten Zwischentransistor ansteuern. Dieser Zwischentransistor liefert den Basisstrom für den Bypass- oder Leistungstransistor, der die Konstantstromquelle überbrückt.

Dadurch dass der vorschlagsgemäße Schalter einen Inverter aufweist, welcher zwischen den Hall-Sensor und den Zwischentransistor geschaltet ist, kann der Sicherheits-Hall-Schalter als 1 Öffner / 1 Schließer ausgestaltet sein.

Vorschlagsgemäß ist weiterhin vorgesehen, dass eine Strombegrenzungsschaltung zum Schutz des Schalters gegen Überlast integriert ist: Über einen Shuntwiderstand wird der Laststrom detektiert. Sobald an ihm die Spannung einen Wert von 0,6V bis 0,7V erreicht, wird ein Transistor leitend, der den Basisstrom für einen zweiten Transistor liefert. Dieser bewirkt, dass der erste Transistor in Selbsthaltung geht, so dass mittels dieser Transistoranordnung ein Thyristor nachgebaut ist. Ein Überlastspeicher dieser Strombegrenzungsschaltung ist vorgesehen, wobei sich das gespeicherte Signal nach Auftreten eines Überstromes nur durch Ausschalten der Versorgungsspannung löschen lässt. Durch die Strombegrenzungsschaltung wird sichergestellt, dass der Sensor nicht dauerhaft überlastet wird und sich dadurch zu stark erhitzt.

Zwischen dem Eingang und dem Ausgang kann vorteilhaft eine Suppressor- oder Transildiode angeordnet sein, welche der Verpolschutzdiode nachgeschaltet ist und Spannungsspitzen kurzschließt.

Der vorschlagsgemäße Schalter kann in vielen Anwendungsfällen einen Reedkontakt ersetzen. Er weist im Vergleich zu einem Reedkontakt eine deutlich höhere Schockfestigkeit auf, weil ausschließlich elektronische Bauteile vorhanden sind und keine mechanische belasteten Bauteile vorgesehen sind. Zudem weist er nur eine Betätigungsebene von vorn auf und ermöglicht eine problemlose Montage auf ferromagnetischem Material, welches bei einem Reedkontakt zu Fehlfunktionen führen könnte.

Bei dem vorschlagsgemäßen Schalter besteht der gesamte Spannungsfall aus der Flussspannung der Verpolschutzdiode, dem Spannungsfall der Emitter-Kollektorstrecke des Leistungstransistors, dem Spannungsfall der Referenzspannungsquelle und dem Spannungsfall über dem Shunt.

Bei einem maximalen Dauerstrom von 250mA ergibt sich somit ein Spannungsfall von etwa 2,5V. Die Leerlaufstromaufnahme liegt bei etwa 80µA bis 130µA. Sie kann bei Verwendung von Bauteilen mit engerer Toleranz noch präziser eingestellt werden. Dieser Strom verursacht an einem Eingangswiderstand von typischen 3kOhm, den eine SPS aufweist, eine Spannung von 0,3V (100µA), so dass ein derart ausgestalteter Schalter in den meisten Anwendungsfällen einen Reedkontakt ersetzen kann.

Bei einer Schaltungsvariante fließt der komplette Laststrom durch die Referenzspannungsdiode bzw. durch den Bypass-Transistor. Alternativ dazu kann der Bypass-Transistor auch nach der Verpolschutzdiode und dem Shuntwiderstand bis zum Ausgang angeordnet werden, wenn die Reihenfolge von Konstantstromquelle und Shuntwiderstand getauscht wird, so dass die Referenzspannungsquelle kleiner ausfallen kann, da sie keinen Laststrom übernehmen muss.

Zwei Ausführungsbeispiele vieradriger Hall-Sicherheitsschalter werden nachfolgend anhand der rein schematischen Darstellung näher erläutert. Dabei zeigt
- Fig. 1: ein erstes Ausführungsbeispiel, wobei die beiden Kanäle als übereinander angeordnete Blockschaltbilder dargestellt sind, und
- Fig. 2: ein zweites Ausführungsbeispiel

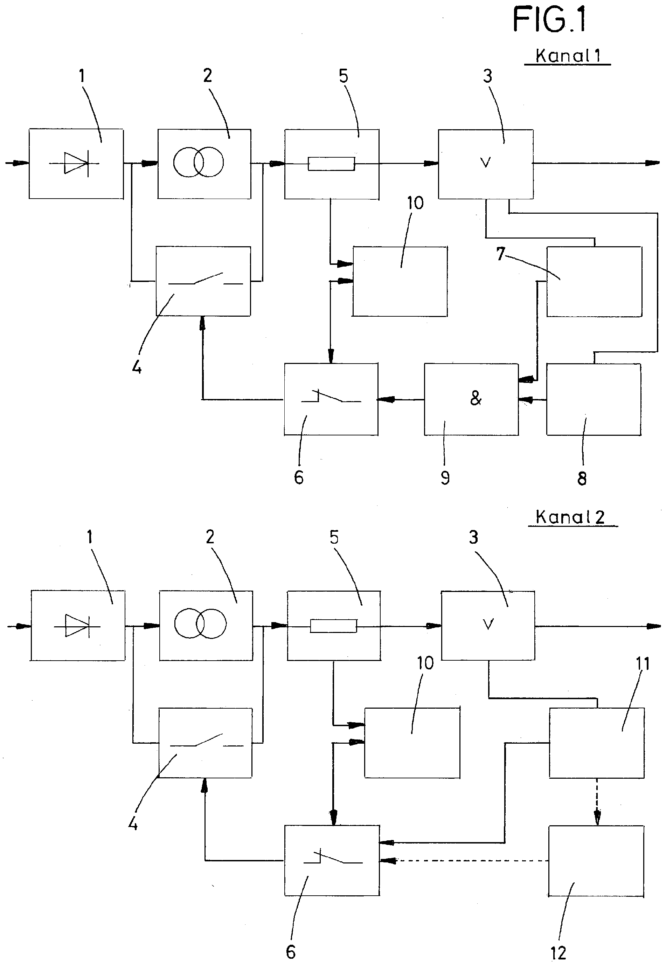

In der Fig. 1 ist ein Blockschaltbild für die beiden Kanäle eines vorschlagsgemäßen Sicherheits-Hall-Schalters wiedergegeben. Dabei ist für jeden der beiden Kanäle jeweils ein als Pfeil dargestellter Eingang links und ein ebenfalls als Pfeil dargestellter Ausgang rechts dargestellt, wobei diese beiden Ein- und Ausgänge die Leitungen bzw. Leitungsadern einer Verkabelung repräsentieren, so dass dementsprechend jeder der beiden Kanäle unter Verwendung von lediglich zwei Anschlussadern angeschlossen werden kann.

Zwischen dem Eingang und dem Ausgang ist bei beiden Kanälen jeweils ein Verpolschutz in Form einer Verpolschutzdiode 1 vorgesehen, welcher eine Konstantstromquelle 2 nachgeschaltet ist sowie eine Referenzspannungsquelle 3, die der Konstantstromquelle 2 nachgeschaltet ist. Weiterhin ist ein die Konstantstromquelle 2 überbrückender Bypass-Transistor bzw. Leistungstransistor 4 vorgesehen, und zwischen der Konstantstromquelle 2 und der Referenzspannungsquelle 3 ist in beiden Kanälen jeweils ein Shuntwiderstand 5 einer Strombegrenzungsschaltung vorgesehen, die zur Abschaltung des gesamten Sensors führt und sich nur durch Ausschalten der Versorgungsspannung löschen lässt.

In beiden Kanälen ist zwischen der Referenzspannungsquelle 3 und dem Leistungstransistor 4 jeweils eine Hall-Sensor-Anordnung vorgesehen, wobei in beiden Kanälen dem Leistungstransistor 4 ein so genannter Zwischentransistor 6 vorgeschaltet ist, der von der Hall-Sensor-Anordnung angesteuert wird.

Im ersten Kanal sind zwei Hall-Sensoren 7 und 8 vorgesehen, denen die Referenzspannung 3 anliegt, wobei die Ausgänge der beiden Hall-Sensoren 7 und 8 jeweils einen Transistor ansteuern und diese beiden Transistoren in Reihe geschaltet sind, so dass sie eine logische und UND-Schaltung schaffen, die in dem Kanal 1 mit 9 gekennzeichnet ist. Nur wenn über diese UND-Schaltung 9 der Zwischentransistor 6 angesteuert ist, kann dieser den Basisstrom für den Leistungstransistor 4 liefern, der die Konstantstromquelle 2 überbrückt.

Ein Überlastspeicher 10 ist als Teil der Strombegrenzungsschaltung vorgesehen, der sowohl mit dem Zwischentransistor 6 als auch mit dem Shuntwiderstand 5 wirksam verbunden ist, so dass dementsprechend bei auftretenden Überlasten oder Kurzschlüssen der Überlastspeicher 10 die Schaltung sperrt und später durch Ausschalten der Versorgungsspannung zurückgesetzt bzw. gelöscht werden kann.

Der Aufbau des zweiten Kanals ist grundsätzlich dem des ersten Kanals gleich, so dass vergleichbare Bauelemente mit denselben Bezugszeichen bezeichnet sind wie beim ersten Kanal. Allerdings umfasst die Hall-Sensor-Anordnung beim zweiten Kanal lediglich einen einzigen, nämlich den dritten in dem Schalter verwendeten Hall-Sensor 11, so dass nur der Ausgang dieses einen Sensors 11 den Zwischentransistor 6 des zweiten Kanals ansteuert.

In gestrichelten Linie ist angedeutet, dass statt des oben beschriebenen Aufbaus des zweiten Kanals das Ausgangssignal des Hall-Sensors 3 mittels eines Inverters 12 invertiert werden kann und dann dieses invertierte Signal den Zwischentransistor 6 ansteuert, so dass auf diese Weise der Schalter in einer Variante "ein Öffner / ein Schließer" ausgestaltet werden kann.

Bei der anhand von Fig. 1 beschriebenen Schaltungsvariante fließt der komplette Laststrom durch die Referenzspannungsdiode 3 bzw. durch den Bypass-Transistor 4, der auch als Last- bzw. Leistungstransistor bezeichnet werden kann und der wie dargestellt parallel zur Stromquelle 2 geschaltet ist.

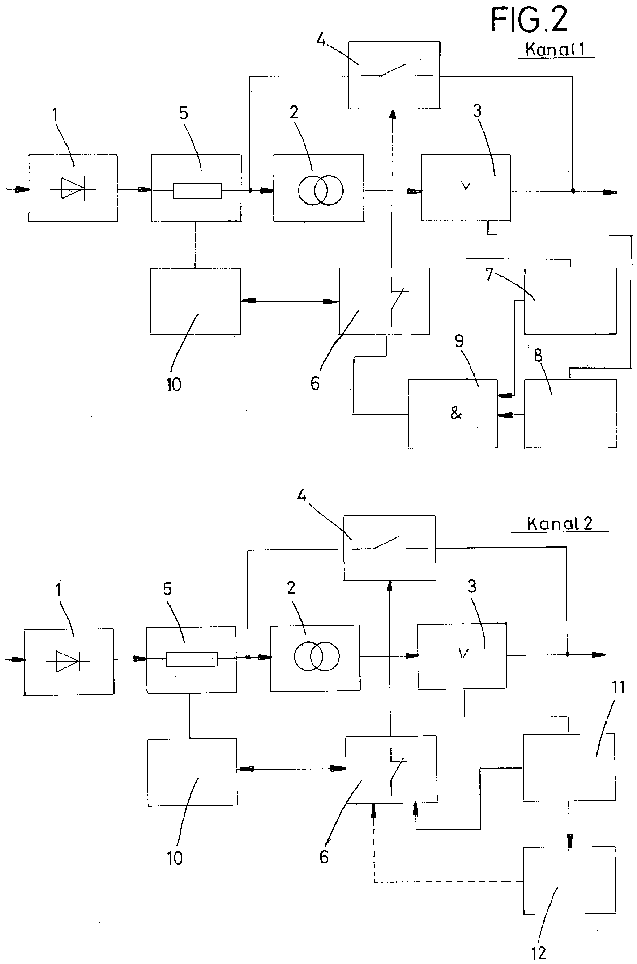

Fig. 2 zeigt ist ein Blockschaltbild für die beiden Kanäle eines zweiten Ausführungsbeispiels eines vorschlagsgemäßen Sicherheits-Hall-Schalters. Gleiche Bauteile sind mit denselben Bezugszeichen gekennzeichnet wie bei der Schaltung von Fig. 1, und auch hier ist im zweiten Kanal eine Schaltungsalternative unter Verwendung eines Inverters 12 möglich. Alternativ zu dem ersten Ausführungsbeispiel von Fig. 1 kann der Last- bzw. Leistungs- bzw. Bypass-Transistor 4 auch nach der Verpolschutzdiode 1 und dem Shuntwiderstand 5 der Strombegrenzungsschaltung bis zum Ausgang angeordnet werden, wenn die Reihenfolge von der Konstantstromquelle 2 und dem Shuntwiderstand 5 der Strombegrenzungsschaltung getauscht wird. Bei dieser Anordnung muss der Last- bzw. Bypass-Transistor 4 im Verstärkerbetrieb auf dem Pegel der Referenzspannungsquelle gehalten werden. Dadurch kann die Referenzspannungsquelle kleiner ausfallen, da sie keinen Laststrom übernehmen muss.

Wie aus den beiden Darstellungen ersichtlich ist, kann der vorschlagsgemäß aufgebaute Sicherheits-Hall-Schalter mit lediglich vier Anschlussadern angeschlossen werden, da nur zwei Anschlussadern pro Kanal vorgesehen sind.

## Patentansprüche

1. Zweikanaliger Sicherheits-Hall-Schalter, wobei in beiden Kanälen jeweils zwischen einem Eingang und einem Ausgang angeordnet sind:
• eine hinter dem Eingang vorgesehene Verpolschutzdiode (1),
• eine dem Verpolschutz nachgeschaltete Konstantstromquelle (2),
wobei ein die Konstantstromquelle (2) überbrückender Leistungstransistor (4) als Bypasstransistor vorgesehen ist,
• eine der Konstantstromquelle nachgeschaltete Referenzspannungsquelle (3),
• eine der Referenzspannungsquelle (3) nachgeschaltete Hall-Sensor-Anordnung
• und wenigstens einen als Zwischentransistor (6) bezeichneten Transistor zwischen der Hall-Sensor-Anordnung und dem Leistungstransistor (4),
wobei in dem ersten Kanal zwei Hall-Sensoren (7, 8) vorgesehen sind, deren Ausgänge jeweils einen Transistor ansteuern, welche in Reihe geschaltet den als Zwischentransistor (6) bezeichneten dritten Transistor ansteuern, der den Basisstrom für den Leistungstransistor (4) liefert, und wobei in dem zweiten Kanal lediglich ein einziger Hall-Sensor (11) vorgesehen ist, dessen Ausgang den Zwischentransistor (6) des zweiten Kanals ansteuert, und im zweiten Kanal zwischen dem Hall-Sensor (11) und dem diesem Hall-Sensor (11) nachgeschalteten Zwischentransistor (6) ein Inverter (12) vorgesehen ist, derart, dass der Sicherheits-Hall-Schalter als 1 Öffner / 1 Schließer ausgestaltet ist,
wobei eine Strombegrenzungsschaltung (5) als Schutz gegen Überlast vorgesehen und zwischen der Konstantstromquelle (2) und der Referenzspannungsquelle (3) angeordnet ist,
wobei ein Shuntwiderstand zur Detektion des Laststroms vorgesehen ist,
sowie ein erster Transistor, der bei einer an dem Shuntwiderstand anliegenden Spannung von 0,6V bis 0,7V leitend wird,
sowie ein zweiter Transistor, dessen Basisstrom von dem ersten Transistor geliefert wird,
wobei der erste und der zweite Transistor in Art eines Nachbaus eines Thyristors derart miteinander verschaltet sind, dass der erste Transistor mittels des zweiten Transistors in Selbsthaltung schaltbar ist,
und wobei jeder Kanal lediglich jeweils einen Eingang und Ausgang aufweist, derart, dass der gesamte Sicherheits-Hall-Schalter mit insgesamt vier Anschlussadern anschließbar ist.

2. Sicherheits-Hall-Schalter nach Anspruch 1,
**dadurch gekennzeichnet,**
**dass** zwischen dem Eingang und dem Ausgang eine Spannungsspitzen kurzschließende Suppressor- oder Transildiode angeordnet ist.

3. Sicherheits-Hall-Schalter nach Anspruch 1 oder 2,
**dadurch gekennzeichnet,**
**dass** die Konstantstromquelle (2) aus einem Junction-FET und einem Widerstand aufgebaut ist.

## Claims

1. Two-channel Hall safety switch, where each of the two channels is arranged between an input and an output:
• a diode (1) for protection against polarity reversal provided behind the input,
• a source of constant current (2) located downstream from the polarity-reversal protection diode, where a power transistor (4) bridging the source (2) of constant current is provided as a bypass transistor,
• a source of reference voltage (3) located downstream from the source of constant current,
• a Hall-sensor arrangement located downstream from the source of reference voltage (3)
• and at least one transistor referred to as the intermediate transistor (6) between the Hall-sensor arrangement and the power transistor (4),
where, in the first channel, two Hall sensors (7, 8) are provided, each of whose outputs controls one transistor which, arranged in series, control a third transistor, referred to as intermediate transistor (6), which supplies the basic current for the power transistor (4), and where, in the second channel, only one Hall sensor (11) is provided, whose output controls the intermediate transistor (6) of the second channel, and where, in the second channel an inverter (12) is provided between the Hall sensor (11) and the intermediate transistor (6) located downstream from that Hall sensor (11),
in such a way that the Hall safety switch is formed as 1 break-contact / 1 make contact,
where a current-limiting circuit (5) is provided as protection against overloading and is arranged between the source of constant current (2) and the reference-voltage source (3),
where a shunt resistor is provided to detect the load current, and a first transistor, which conducts electricity when a voltage of between 0,6 V and 0,7 V is applied to the shunt resistor, and a second transistor whose basic current is supplied by the first transistor, where the first and the second transistor are connected to one another to imitate a thyristor in such a way that the first transistor can be switched into self-lock by means of the second transistor, and where each of the channels has only one input and one output such that the entire Hall safety switch can be connected to a total of four leads.

2. Hall safety switch in accordance with claim 1,
**characterised in that** a suppressor or transil diode is arranged between the input and the output to short-circuit voltage spikes.

3. Hall safety switch in accordance with claim 1 or claim 2, **characterised in that** the source (2) of constant current is constructed from a junction FET and a resistor.

## Revendications

1. Commutateur de sécurité à effet Hall à deux canaux, sachant que dans les deux canaux sont respectivement disposés, entre une entrée et une sortie :
• une diode de protection contre l'inversion de polarité (1) prévue derrière l'entrée,
• une source de courant constant (2) montée en aval du système de protection contre l'inversion de polarité, sachant qu'est prévu un transistor de puissance (4) officiant de transistor de bypass qui ponte la source de courant constant (2),
• une source de tension de référence (3) en aval de la source de courant constant,
• un montage avec capteur à effet Hall disposé en aval de la source de tension de référence (3)
• et au moins un transistor appelé transistor intermédiaire (6) situé entre le montage avec capteur à effet Hall et le transistor de puissance (4),
sachant que dans le premier canal sont prévus deux capteurs à effet Hall (7, 8) dont les sorties excitent respectivement un transistor, qui connectées en série excitent un troisième transistor appelé transistor intermédiaire (6) qui délivre le courant de base nécessaire au transistor de puissance (4),
et sachant que dans le deuxième canal est prévu seulement un unique capteur à effet Hall (11) dont la sortie excite le transistor intermédiaire (6) du deuxième canal, et que dans le deuxième canal est prévu un convertisseur (12) entre le capteur à effet Hall (11) et le transistor intermédiaire (6) monté en aval de ce capteur à effet Hall (11),
de sorte que le commutateur de sécurité à effet Hall est configuré en contact 1 de repos / contact 1 de travail,
sachant qu'est prévu un circuit limiteur de courant (5) qui protège contre la surcharge et qui est disposé entre la source de courant constant (2) et la source de tension de référence (3),
sachant que sont prévus une résistance de shuntage pour détecter le courant de charge
ainsi qu'un premier transistor qui devient conducteur lorsque la tension appliquée à la résistance de shuntage est comprise entre 0,6 V et 0,7 V,
ainsi qu'un deuxième transistor dont le courant de base est délivré par le premier transistor,
sachant que le premier et le deuxième transistors sont interconnectés de façon à reproduire un thyristor, de sorte que le premier transistor est commutable en auto-maintien à l'aide du deuxième transistor,
et sachant que chaque canal présente uniquement et respectivement une entrée et une sortie, de sorte que l'ensemble du commutateur de sécurité à effet Hall est raccordable à l'aide d'au total quatre fils.

2. Commutateur de sécurité à effet Hall selon la revendication 1, **caractérisé en ce qu'**entre l'entrée et la sortie est disposée une diode de suppression ou diode Transil court-circuitant des pics de tension.

3. Commutateur de sécurité à effet Hall selon la revendication 1 ou 2, **caractérisé en ce que** la source de courant constant (2) est formée d'un transistor à effet de champ à jonction et d'une résistance.
